# EUROPEAN PATENT APPLICATION

(11) **EP 3 203 039 A1**
(43) Date of publication of application: **09.08.2017**
(21) Application number: 16205164.3
(22) Date of filing: 19.12.2016
(51) Int. Cl.: F01D 25/12, H05K 7/20

(54) **GAS TURBINE ENGINE COOLING SYSTEM, CORRESPONDING GAS TURBINE ENGINE AND METHOD OF COOLING**

(30) Priority: 28.12.2015 US 201514981580
(71) Applicant: General Electric Company, Schenectady, NY 12345 (US)
(72) Inventor: ELBIBARY, Mohamed, West Chester, OH 45069 (US); RIAZ, Shahi, West Chester, OH 45069 (US)
(74) Representative: Williams, Andrew Richard

(57) **Abstract**

A gas turbine engine cooling system (400,500,600) includes a gas turbine engine (100). The gas turbine engine includes a core engine (102), a cold sink (602,202,316,302,702), a core undercowl space (131), and a core cowl (130) at least partially surrounding the core engine and defining a radially outer wall of the core undercowl space. The gas turbine engine cooling system includes an undercowl component (402) positioned in the core undercowl space. The gas turbine engine cooling system also includes a heat pipe (414) including a first end (416), a second end (418), and a conduit (420) extending therebetween. The first end is thermally coupled to the undercowl component, and the second end is thermally coupled to the cold sink. The heat pipe facilitates transfer of a quantity of heat from the undercowl component to the cold sink.

## Description

### BACKGROUND

The field of the disclosure relates generally to turbine engines and, more particularly, to a system and method using heat pipes for transferring heat within a gas turbine engine.

Gas turbine engines typically include an undercowl compartment as a part of the engine architecture. As gas turbine engines are improved to, for example, result in higher speeds of aircraft, core undercowl temperature is expected to rise substantially. Undercowl components include electronics and other line replaceable units (LRUs). Such electronic components in known gas turbine engines, including full authority digital engine (or electronics) controls (FADECs), may be particularly sensitive to increasing core undercowl temperatures both during gas turbine engine operation and during soakback after engine shutdown. For example, servicing electronics in at least some known gas turbine engines requires the engine to remain in ground idle (GI) for at least 3 minutes after flight. In such known gas turbine engines, strategies to cool electronic undercowl components include dedicated active cooling systems including piping, changing materials of construction, and modifying engine architecture by placing heat radiation shields around electronics and by moving components to remote locations.

Known systems with piping for active cooling of undercowl electronics and use of radiation shields add weight to gas turbine engines and, therefore, increase the specific fuel consumption (SFC). Where such components are placed at remote locations in the engine, increases in the length of connecting cables also increases engine weight and SFC while also complicating maintenance activities. Furthermore, in such known gas turbine engines, such problems are compounded during soakback where there is no cooling flow and an extended time must be waited after operation of such known gas turbine engines before servicing them. Some known systems and methods for cooling undercowl components also increase operating costs of at least some known gas turbine engines.

### BRIEF DESCRIPTION

In one aspect, a gas turbine engine cooling system is provided. The gas turbine engine includes a core engine, a cold sink, a core undercowl space, and a core cowl at least partially surrounding the core engine and defining a radially outer wall of the core undercowl space. The gas turbine engine cooling system includes an undercowl component positioned in the core undercowl space. The gas turbine engine cooling system also includes a heat pipe including a first end, a second end, and a conduit extending therebetween. The first end is thermally coupled to the undercowl component, and the second end is thermally coupled to the cold sink. The heat pipe facilitates transfer of a quantity of heat from the undercowl component to the cold sink.

In another aspect, a gas turbine engine is provided. The gas turbine engine includes a core engine, a cold sink, a core undercowl space, and a core cowl at least partially surrounding the core engine and defining a radially outer wall of the core undercowl space. The gas turbine engine also includes an undercowl component positioned in the core undercowl space. The gas turbine engine further includes a cooling system. The cooling system includes a heat pipe including a first end, a second end, and a conduit extending therebetween. The first end is thermally coupled to the undercowl component, and the second end is thermally coupled to the cold sink. The heat pipe facilitates transfer of a quantity of heat from the undercowl component to the cold sink.

In yet another aspect, a method of cooling a gas turbine engine is provided. The gas turbine engine includes a core engine, a cold sink, a core undercowl space, an undercowl component positioned in the core undercowl space, and a core cowl at least partially surrounding the core engine and defining a radially outer wall of the core undercowl space. The gas turbine engine also includes an undercowl component positioned in the core undercowl space. The method includes selecting a heat pipe having performance parameters to facilitate following a predetermined heat transfer characteristic including a thermal resistance between the undercowl component and the cold sink. The method also includes thermally coupling a first end of the heat pipe to the undercowl component. The method further includes thermally coupling a second end of the heat pipe to the cold sink. The method also includes receiving heat into the first end from the undercowl component. The method further includes transferring heat through the heat pipe to the cold sink.

### BRIEF DESCRIPTION OF THE DRAWINGS

These and other features, aspects, and advantages of the present disclosure will become better understood when the following detailed description is read with reference to the accompanying drawings in which like characters represent like parts throughout the drawings, wherein:
FIGS. 1-6 show example embodiments of the apparatus and method described herein.
FIG. 1 is a schematic illustration of an exemplary gas turbine engine.
FIG. 2 is a perspective view from forward to aft of an exemplary annular fan casing which may be used in the gas turbine engine shown in FIG. 1.
FIG. 3 is a perspective view from forward to aft of an exemplary fan module which may be used in the gas turbine engine shown in FIG. 1.
FIG. 4 is a schematic diagram of an exemplary embodiment of a passive thermal management system for an undercowl component that may be used in the gas turbine engine shown in FIG. 1.
FIG. 5 is a perspective view from aft to forward of an alternative embodiment of a passive thermal management system for an undercowl component which may be used with the gas turbine engine shown in FIG. 1.
FIG. 6 is a schematic diagram of another alternative embodiment of a passive thermal management system for an undercowl component, which may be used with the gas turbine engine shown in FIG. 1.

Although specific features of various embodiments may be shown in some drawings and not in others, this is for convenience only. Any feature of any drawing may be referenced and/or claimed in combination with any feature of any other drawing.

Unless otherwise indicated, the drawings provided herein are meant to illustrate features of embodiments of the disclosure. These features are believed to be applicable in a wide variety of systems comprising one or more embodiments of the disclosure. As such, the drawings are not meant to include all conventional features known by those of ordinary skill in the art to be required for the practice of the embodiments disclosed herein.

### DETAILED DESCRIPTION

In the following specification and the claims, reference will be made to a number of terms, which shall be defined to have the following meanings.

The singular forms "a", "an", and "the" include plural references unless the context clearly dictates otherwise.

"Optional" or "optionally" means that the subsequently described event or circumstance may or may not occur, and that the description includes instances where the event occurs and instances where it does not.

Approximating language, as used herein throughout the specification and claims, may be applied to modify any quantitative representation that could permissibly vary without resulting in a change in the basic function to which it is related. Accordingly, a value modified by a term or terms, such as "about", "approximately", and "substantially", are not to be limited to the precise value specified. In at least some instances, the approximating language may correspond to the precision of an instrument for measuring the value. Here and throughout the specification and claims, range limitations may be combined and/or interchanged, and such ranges are identified and include all the sub-ranges contained therein unless context or language indicates otherwise.

The following detailed description illustrates embodiments of the disclosure by way of example and not by way of limitation. It is contemplated that the disclosure has general application to a method and system for using heat pipes for transferring heat within a gas turbine engine.

Embodiments of the soakback mitigation through passive cooling systems and methods described herein effectively decrease the temperature of core undercowl components, including temperature sensitive electronics such as full authority digital engine (or electronics) controls (FADECs) and fuel operated valves, both during operation and soakback of gas turbine engines. Also, the soakback mitigation through passive cooling systems and methods described herein make it possible to reduce post-flight ground idle (GI) time before maintenance activities on gas turbine engines may be performed. Further, the soakback mitigation through passive cooling systems and methods described herein reduce the specific fuel consumption (SFC) of gas turbine engines by replacing dedicated active cooling systems and methods and radiation shields with lower weight passive cooling systems and methods including heat pipes. Furthermore, the soakback mitigation through passive cooling systems and methods described herein simplify maintenance activities on undercowl components and reduce operating costs of gas turbine engines by avoiding having to change materials of construction of undercowl components and having to change engine architecture to move undercowl components to remote and more difficult to service locations.

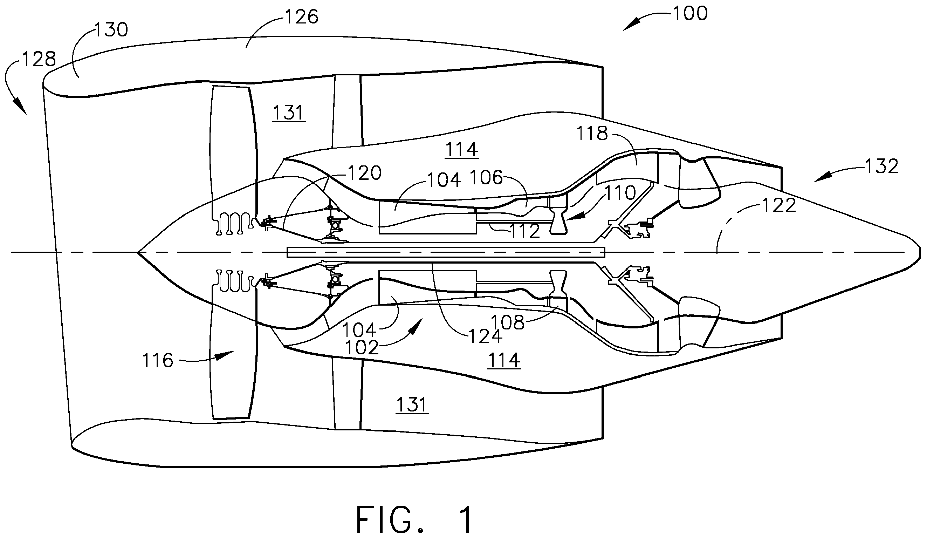

FIG. 1 is a schematic illustration of an exemplary gas turbine engine 100. Gas turbine engine 100 includes a gas generator or core engine 102 that includes a high pressure compressor (HPC) 104, a combustor assembly 106, and a high pressure turbine (HPT) 108 in an axial serial flow relationship on a core engine rotor 110 rotating about a core engine shaft 112. HPC 104, combustor assembly 106, HPT 108, core engine rotor 110, and core engine shaft 112 are located inside of an annular housing 114. Gas turbine engine 100 also includes a low pressure compressor or fan 116 and a low pressure turbine (LPT) 118 arranged in an axial flow relationship on a power engine rotor 120.

During operation of exemplary gas turbine engine 100, air flows along a central axis 122, and compressed air is supplied to HPC 104. The highly compressed air is delivered to combustor assembly 106. Exhaust gas flows (not shown in FIG. 1) from combustor assembly 106 and drives HPT 108 and LPT 118. Power engine shaft 124 drives power engine rotor 120 and fan 116. Gas turbine engine 100 also includes a fan or low pressure compressor containment case 126. Also, in the exemplary gas turbine engine 100, an initial air inlet 128 located at the forward end of gas turbine engine 100 includes a core cowl 130 defining a circumferential boundary thereof. Core cowl 130 at least partially surrounds core engine 102. Also, core cowl 130 defines a radially outer wall of a core undercowl space 131. Within core undercowl space 131 is annular housing 114 and components of gas turbine engine 100 within annular housing 114 described above. Throughout gas turbine engine 100, valves of various types, not shown, are present and control flow of various liquids and gases including, without limitation, fuel, intake air, and exhaust gas. At least some valves in gas turbine engine 100 establish temperature gradients between fluids and gases whereby fluids and gases on one side of the valve are at a higher or lower temperature than the other side of the valve. Further, gas turbine engine 100 includes an aft end including an exhaust outlet 132.

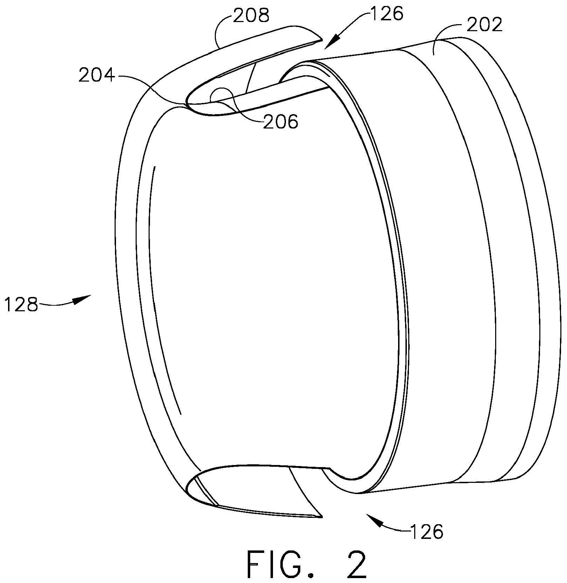

FIG. 2 is a perspective view from forward to aft of an exemplary annular fan casing which may be used in gas turbine engine 100 shown in FIG. 1. Core cowl 130 is disposed forward of an annular fan casing 202. Core cowl 130 has a generally "U"-shaped cross-section with a curved portion defining an inlet lip 204, an inner wall 206, extending aft of inlet lip 204 in a generally axial direction, and an outer wall 208 extending aft of inlet lip 204 in a generally axial direction. Annular fan casing 202 is configured to house and support fan 116 (not shown in FIG. 2). Inner wall 206 forms a flowpath for air entering annular fan casing 202, and outer wall 208 is exposed to external air flow.

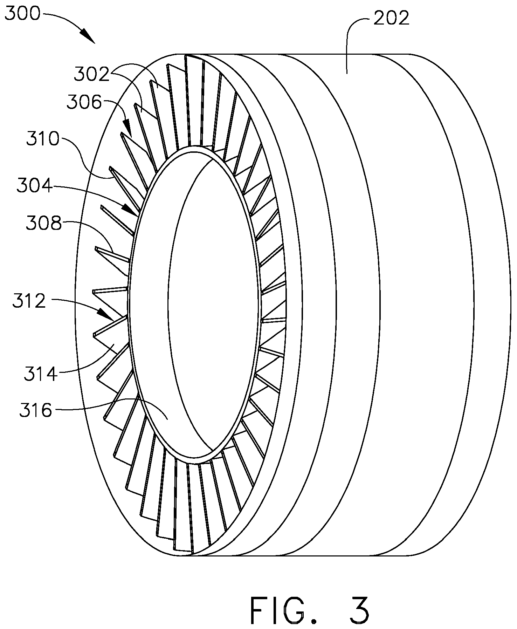

FIG. 3 is a perspective view from forward to aft of an exemplary fan module 300 which may be used in gas turbine engine 100 shown in FIG. 1. Fan module 300 includes a plurality of outlet guide vanes (OGVs) 302 coupled to and disposed within annular fan casing 202. Each OGV of the plurality of OGVs 302 includes a root 304, a tip 306, a leading edge 308, a trailing edge 310, and opposed sides 312 and 314. OGVs 302 are airfoil-shaped and are positioned and oriented to remove a tangential swirl component from the air flow exiting an upstream fan, not shown.

In operation, in the exemplary fan module 300, OGVs 302 serve as structural members (sometimes referred to as "fan struts") which connect annular fan casing 202 to an annular inner housing 316. In alternative embodiments, not shown, these support functions may be served by other or additional components. OGVs 302 are constructed from any material which has adequate strength to withstand the expected operating loads and which can be formed in the desired shape. Use of thermally conductive material for OGVs 302 enhances heat transfer in gas turbine engine 100, not shown.

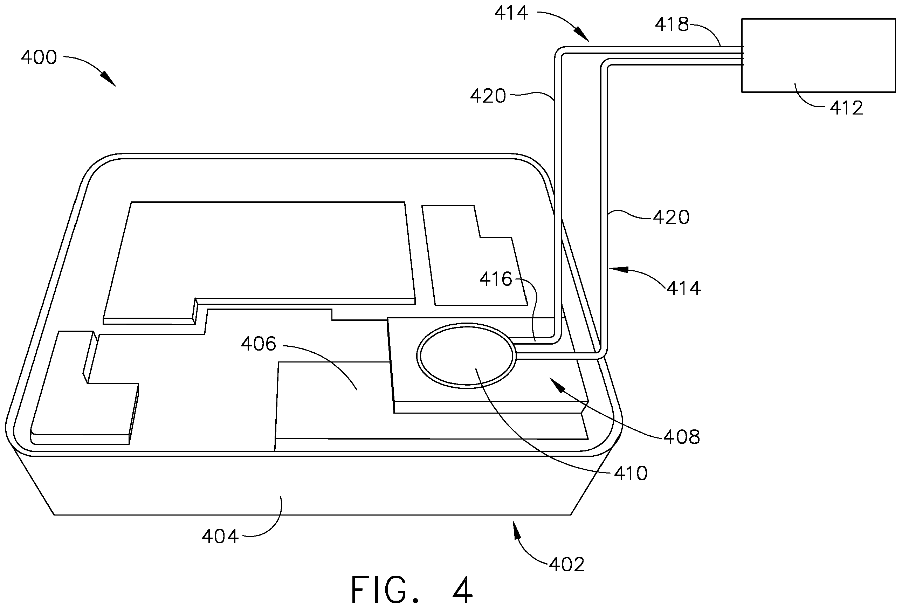

FIG. 4 is a schematic diagram of an exemplary embodiment of a passive thermal management system 400 for an undercowl component 402 that may be used in the gas turbine engine 100 shown in FIG. 1. In the exemplary embodiment, passive thermal management system 400 includes at least one undercowl component 402, including, without limitation, FADEC and electronic components. Undercowl component 402 includes, by way of example only, FADEC chassis 404 within or upon which at least one electronic component, including, without limitation, at least one circuit board 406 resides. Also, in the exemplary embodiment, at least one heat source 408, including, without limitation, a heat sink constructed of a more thermally conductive material than circuit board 406, is thermally coupled to circuit board 406 to facilitate heat transfer therebetween. Further, in the exemplary embodiment, heat source 408 is thermally coupled to at least one of the most thermally sensitive circuit board 406 of a plurality of circuit boards 406 within FADEC chassis 404. In other alternative embodiments, not shown, heat source 408 is thermally coupled to all circuit boards 406 of a plurality of circuit boards 406 within FADEC chassis 404. Furthermore, in the exemplary embodiment, heat source 408 includes an evaporator 410 thermally coupled thereto. Moreover, in the exemplary embodiment, passive thermal management system 400 includes a condenser 412.

Also, in the exemplary embodiment, passive thermal management system 400 includes at least one heat pipe 414. Heat pipe 414 is thermally coupled to and between evaporator 410 and condenser 412. Further, in the exemplary embodiment, heat pipe 414 includes a first end 416, a second end 418, and a conduit 420 extending therebetween. The majority of each heat pipe 414 is wrapped with suitable thermal insulation, not shown. At least a portion of each second end 418 is uninsulated. First end 416 is disposed upon or within evaporator 410. Second end 418 is disposed upon or within condenser 412. In other alternative embodiments, not shown, evaporator 410 and condenser 412 are not separate components, but rather are integrally formed as parts of first end 416 and second end 418, respectively. In still other embodiments, not shown, evaporator 410 and/or condenser 412 are not present, and heat pipe 414 is thermally coupled to and between heat source 408 and a cold sink, not shown in FIG. 4, located on at least one portion of gas turbine engine 100, including, without limitation, locations outside of gas turbine engine 100, which are of a lower temperature than heat source 408.

In operation, in the exemplary embodiment, first end 416 and second end 418 are mounted within or upon evaporator 410 and condenser 412, respectively, so as to achieve good thermal conductivity therebetween. Also, in operation of the exemplary embodiment, heat source 408 is at a higher temperature than condenser 412, including, without limitation, on account of condenser being located further away from gas turbine engine 100 or in a region thereof having a lower temperature than heat source 408. Under those conditions, heat from heat source 408 is transferred from first end 416 to second end 418 of heat pipe 414.

Also, in operation of the exemplary embodiment, each heat pipe 508 has an elongated outer wall with closed ends which together define a cavity. The cavity is lined with a capillary structure or wick, not shown in FIG. 4, and holds a working fluid. Various working fluids, such as gases, water, organic substances, and low-melting point metals are known for use in heat pipes 414. Further, in operation of the exemplary embodiment, heat pipes 414 are highly efficient at transferring heat. For example, their effective thermal conductivity is several orders of magnitude higher than that of solid copper. The number, length, diameter, shape, working fluid, and other performance parameters of heat pipes 414 are selected based on the desired degree of heat transfer during engine operation, as well as during soakback. Furthermore, in operation of the exemplary embodiment, the characteristics of heat pipes 414, evaporators 410, and condensers 412, including, without limitation, their shape, length, diameter, and thickness, may be varied to accommodate their individual orientations and placements within gas turbine engine 100. As such, individual designs for heat pipes 414 may require stronger capillary action to ensure adequate condensate return depending on the particular application within gas turbine engine 100.

Further, in operation of the exemplary embodiment, heat from heat source 408 circulates into evaporator 410 where it heats first end 416 of heat pipe 414. Working fluid within heat pipe 414 absorbs that heat and evaporates. The vapor thus generated then travels through the cavities inside heat pipe 414, and condenses at second end 418, thereby transferring heat from heat source 408 to colder areas of gas turbine engine 100 proximate condenser 412. Condensed working fluid then transports, including, without limitation, by capillary action, from second end 418 back to first end 416 at hotter areas of gas turbine engine 100, including, without limitation, heat source 408, thereby completing the circuit. Furthermore, in operation of the exemplary embodiment, the resultant heat transfer from heat source 408 to condenser 412 facilitates passive thermal management system 400 providing effective prevention of ice formation (i.e. anti-icing) and/or ice removal in areas of gas turbine engine 100 proximate condenser 412, depending on the heating rate. Moreover, in operation of the exemplary embodiment, passive thermal management system 400 is passive and, therefore, needs no valves and is sealed. The number, size, and location of heat pipes 414 can be selected to provide heat removal and heat transfer as needed.

Furthermore, in operation of the exemplary embodiment, depending upon the exact configuration chosen, the system performance may be used only for anti-icing or for de-icing. The gas turbine engine cooling system makes use of heat which is undesired in one portion of an engine and uses that heat where it is need in another portion of the engine, avoiding both the losses associated with known cooling systems and the need for a separate anti-icing heat source.

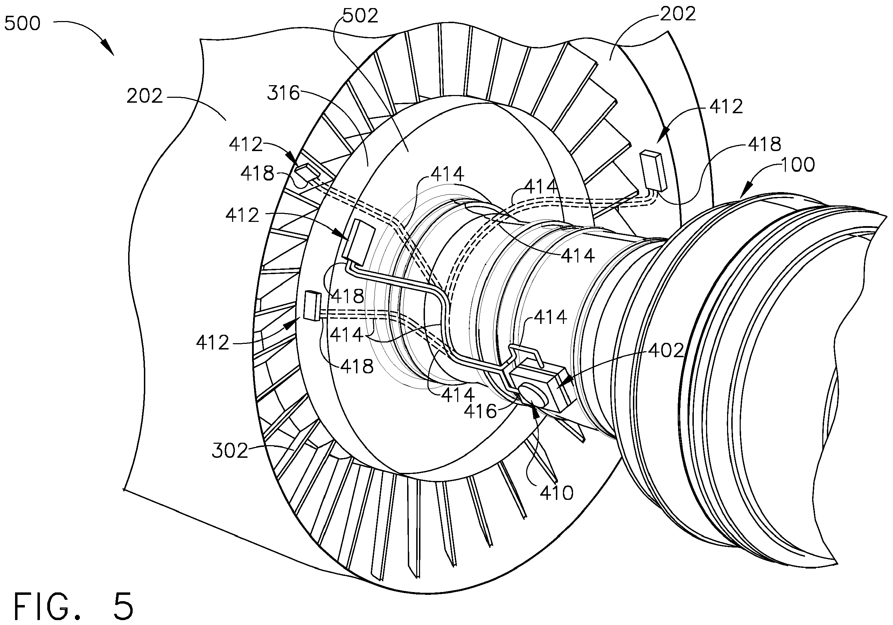

FIG. 5 is a perspective view from aft to forward of an alternative embodiment of a passive thermal management system 500 for an undercowl component 402 which may be used with the gas turbine engine 100 shown in FIG. 1. In the alternative embodiment, passive thermal management system 500 includes at least one undercowl component 402 coupled to at least one portion of gas turbine engine 100. Also, in the alternative embodiment, undercowl component 402 is an electronic component, including, without limitation an exciter box or FADEC, within which is at least one heat source 408 thermally coupled to evaporator 410, as shown and described above with reference to FIG. 4. Further, in the alternative embodiment, passive thermal management system 500 includes at least one condenser 506 coupled to at least one portion of a thrust link support 702. Annular inner housing 316 is coupled to thrust link support 702 at aft facing portions thereof, thus forming a circumferential cap thereto. Condenser 412 is thermally coupled to at least one aft facing portion of thrust link support 702. In other alternative embodiments, not shown, condenser 412 is thermally coupled to at least one forward portion, not shown, of thrust link support 702, either alone, or in combination with at least one aft facing portion thereof.

Also, in the alternative embodiment, passive thermal management system 500 includes at least one heat pipe 414. Heat pipe 414 is thermally coupled to and between evaporator 410 and condenser 412, as shown and described above with reference to FIG. 4. Evaporator 410 is thermally coupled to heat source 408 inside undercowl component 402. In other alternative embodiments, not shown, heat pipe 414 is thermally coupled to evaporator 410 and also coupled to heat source 408. Further, in the alternative embodiment, heat pipe 414 is further coupled to thrust link support 702. In other alternative embodiments, not shown, heat pipe 414 is not coupled to thrust link support 702, but rather is coupled to other portions of gas turbine engine 100, or, alternatively, not coupled to other portions of gas turbine engine 100.

Further, in the alternative embodiment, passive thermal management system 500 includes at least one condenser 412 thermally coupled to at least one of opposed sides 312 and 314 of at least one OGV 302 disposed within annular fan casing 202. Heat pipe 414 (depicted in dashed lines in FIG. 5) is thermally coupled to and between evaporator 410 and condenser 412, as shown and described above with reference to FIG. 4. Furthermore, in the alternative embodiment, heat pipe 414 is further coupled to annular inner housing 316. In other alternative embodiments, not shown, heat pipe 414 is not coupled to annular inner housing 316, but rather is coupled to other portions of gas turbine engine 100, or, alternatively, not coupled to other portions of gas turbine engine 100.

Furthermore, in the alternative embodiment, passive thermal management system 500 includes at least one condenser 412 coupled to at least one portion of annular inner housing 316 including, without limitation, on a radially outward surface thereof. In other alternative embodiments, not shown, at least one condenser 412 is thermally coupled to at least one portion of radially inward surfaces of annular inner housing 316, not shown, either alone, or in combination with at least one radially outward surface thereof. Heat pipe 414 is thermally coupled to and between evaporator 410 and condenser 412, as shown and described above with reference to FIG. 4. Moreover, in the alternative embodiment, heat pipe 414 is further coupled to annular inner housing 316. In other alternative embodiments, not shown, heat pipe 414 is not coupled to annular inner housing 316, but rather is coupled to other portions of gas turbine engine 100, or, alternatively, not coupled to other portions of gas turbine engine 100.

Moreover, in the alternative embodiment, passive thermal management system 500 includes at least one condenser 412 coupled to at least one portion of annular fan casing 202 including, without limitation, on a radially inward surface thereof. Heat pipe 414 is thermally coupled to and between evaporator 410 and condenser 412, as shown and described above with reference to FIG. 4. Also, in the alternative embodiment, at least one heat pipe 414 is thermally coupled to and between condensers 412 thermally coupled to annular inner housing 316, OGV 302, thrust link support 702, annular fan casing 202, and combinations thereof, and at least one evaporator 410 coupled to at least one heat source 408 on at least one undercowl component 402.

In operation, in the alternative embodiment, undercowl component 402 is typically at a higher temperature than thrust link support 702, OGV 302, annular fan casing 202, and annular inner housing 316 during typical operating conditions of gas turbine engine 100, including during soakback. As such, thrust link support 702, OGV 302, and annular inner housing 316 are cold sinks to which condenser 412 are thermally coupled. As described above with reference to FIG. 4, heat source 408 transfers heat to evaporator 410. Evaporator 410 heats first end 416 of heat pipe 414. Heat is transferred through heat pipe 414 to the cooler second end 418 proximate condenser 412 coupled to at least one of thrust link support 702, OGV 302, annular fan casing 202, and annular inner housing 316, thus passively cooling undercowl component 402.

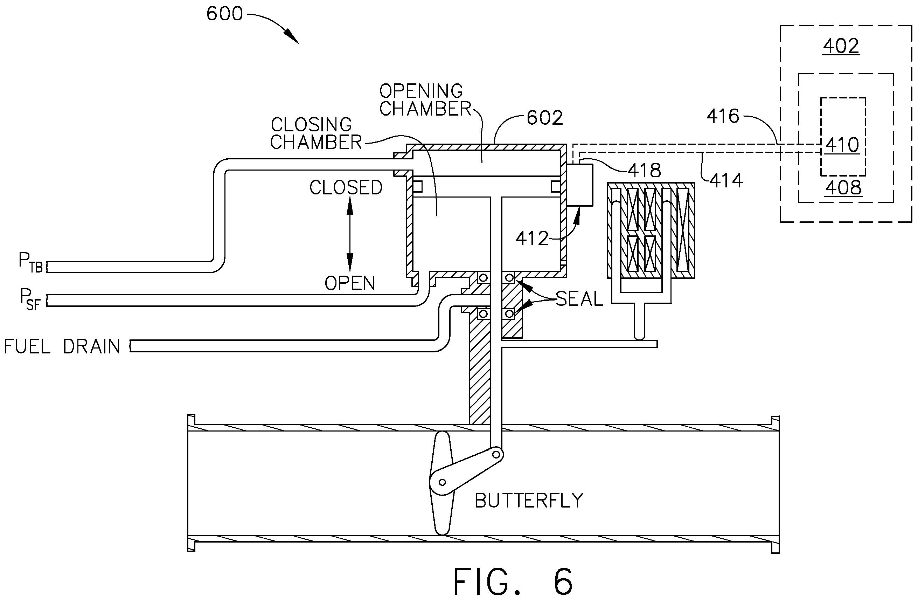

FIG. 6 is a schematic diagram of another alternative embodiment of a passive thermal management system 600 for an undercowl component 402 which may be used with the gas turbine engine 100 shown in FIG. 1. In the alternative embodiment, passive thermal management system 600 includes at least one undercowl component 402 coupled to at least one portion of gas turbine engine 100. Also, in the alternative embodiment, undercowl component 402 is an electronic component including, without limitation, a FADEC, within which is at least one heat source 408 thermally coupled to at least one evaporator 410. Further, in the alternative embodiment, passive thermal management system 600 includes at least one condenser 412 coupled to at least one portion of at least one valve body 602. Valve body 602 is coupled to at least one portion of gas turbine engine 100 as described above with reference to FIG. 1. At least one condenser 412 is thermally coupled to valve body 602.

Also, in the alternative embodiment, passive thermal management system 600 includes at least one heat pipe 414. Heat pipe 414 is thermally coupled to and between evaporator 410 and condenser 512, as shown and described above with reference to FIG. 4. Evaporator 410 is thermally coupled to heat source 408 inside undercowl component 402. In other alternative embodiments, not shown, heat pipe 414 is thermally coupled to evaporator 410 and also coupled to heat source 408. Further, in the alternative embodiment, heat pipe 414 is further coupled to valve body 602. In other alternative embodiments, not shown, heat pipe 414 is not coupled to valve body 602, but rather is coupled to other portions of gas turbine engine 100, or, alternatively, not coupled to other portions of gas turbine engine 100. In still other alternative embodiments, not shown, valve body 602 is heat source 408 and at least one evaporator 410 is coupled thereto. Where valve body 602 is an undercowl component 402 and a heat source 408, i.e., where valve body 602 is part of a fuel operated and/or fuel-cooled valve inside of or proximate gas turbine engine 100, passive thermal management system 600 enables the fuel cooling system can be replaced with heat pipes 414, as shown and described above with reference to FIG. 4.

In operation, in the alternative embodiment, undercowl component 402 is typically at a higher temperature than valve body 602 during typical operating conditions of gas turbine engine 100, including during soakback. Also, in operation of the alternative embodiment, the temperature difference between undercowl component 402 and valve body 602 is greatest when valve body 602 contains a volume of cooler liquids and gases, including, without limitation, fuel and air from outside gas turbine engine 100, relative to liquids and gases from within gas turbine engine 100. As such, valve body 602 is a cold sink to which condenser 412 is thermally coupled. As described above with reference to FIG. 4, heat source 408 transfers heat to evaporator 410. Evaporator 410 heats first end 416 of heat pipe 414. Heat is transferred through heat pipe 414 to the cooler second end 418 proximate condenser 412 thermally coupled to valve body 602, thus passively cooling undercowl component 402.

The above-described embodiments of soakback mitigation through passive cooling systems and methods effectively decrease the temperature of core undercowl components, including temperature-sensitive electronics such as FADECs, exciter boxes, fuel operated valves, and valve bodies, both during operation and soakback of gas turbine engines. Also, the above described soakback mitigation through passive cooling systems and methods make it possible to reduce post-flight GI time before maintenance activities on gas turbine engines may be performed. Further, the above-described soakback mitigation through passive cooling systems and methods reduce the SFC of gas turbine engines by replacing dedicated active cooling systems and methods and radiation shields with lower weight passive cooling systems and methods including heat pipes. Furthermore, the above-described soakback mitigation through passive cooling systems and methods simplify maintenance activities on undercowl components 402 and reduce operating costs of gas turbine engines by avoiding having to change materials of construction of undercowl components 402 and having to change engine architecture to move undercowl components 402 to remote and more difficult to service locations.

Example systems and apparatus of soakback mitigation through passive cooling systems and methods are described above in detail. The apparatus illustrated is not limited to the specific embodiments described herein, but rather, components of each may be utilized independently and separately from other components described herein. Each system component can also be used in combination with other system components.

This written description uses examples to describe the disclosure, including the best mode, and also to enable any person skilled in the art to practice the disclosure, including making and using any devices or systems and performing any incorporated methods. The patentable scope of the disclosure is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

Various aspects and embodiments of the present invention are defined by the following numbered clauses:
1. A gas turbine engine cooling system for a gas turbine engine, the gas turbine engine including a core engine, a cold sink, a core undercowl space, and a core cowl at least partially surrounding the core engine and defining a radially outer wall of the core undercowl space, said gas turbine engine cooling system comprising:
   an undercowl component positioned in the core undercowl space; and
   a heat pipe comprising a first end, a second end, and a conduit extending therebetween, said second end thermally coupled to the cold sink, said first end thermally coupled to said undercowl component, wherein said heat pipe facilitates transfer of a quantity of heat from said undercowl component to the cold sink.
2. The gas turbine engine cooling system in accordance with clause 1, wherein said undercowl component comprises an electronic component.
3. The gas turbine engine cooling system in accordance with clause 1 or 2, wherein said electronic component comprises a full authority digital engine (or electronics) control (FADEC).
4. The gas turbine engine cooling system in accordance with any preceding clause, wherein said undercowl component comprises a non-electronic component.
5. The gas turbine engine cooling system in accordance with any preceding clause, further comprising at least one condenser thermally coupled to and between said second end and the cold sink.
6. The gas turbine engine cooling system in accordance with any preceding clause, further comprising at least one evaporator thermally coupled to and between said first end and said undercowl component.
7. The gas turbine engine cooling system in accordance with any preceding clause, wherein the cold sink comprises a valve body, an annular fan casing, an annular inner housing, an outer guide vane, and a thrust link support.
8. The gas turbine engine cooling system in accordance with any preceding clause, wherein said electronic component comprises a circuit board, a heat sink, and a chassis, the circuit board disposed inside of the chassis, the heat sink thermally coupled to the circuit board, said first end thermally coupled to the heat sink, said heat pipe extending through the chassis, wherein:
   the heat sink facilitates transfer of the quantity of heat from the circuit board to said first end; and
   said heat pipe facilitates further transfer of the quantity of heat from said first end to said cold sink.
9. A gas turbine engine comprising:
   a core engine;
   a cold sink;
   a core undercowl space;
   a core cowl at least partially surrounding said core engine and defining a radially outer wall of said core undercowl space;
   an undercowl component positioned in said core undercowl space; and
   a cooling system comprising a heat pipe including a first end, a second end, and a conduit extending therebetween, said second end thermally coupled to said cold sink, said first end thermally coupled to said undercowl component, wherein said heat pipe facilitates transfer of a quantity of heat from said undercowl component to said cold sink.
10. The gas turbine engine in accordance with clause 9, wherein said undercowl component comprises an electronic component.
11. The gas turbine engine a clause 9 or 10, wherein said electronic component comprises a full authority digital engine (or electronics) control (FADEC).
12. The gas turbine engine in accordance with any of clauses 9 to 11, wherein said undercowl component comprises a non-electronic component.
13. The gas turbine engine in accordance with any of clauses 9 to 12, further comprising at least one condenser thermally coupled to and between said second end and said cold sink.
14. The gas turbine engine in accordance with any of clauses 9 to 13, further comprising at least one evaporator thermally coupled to and between said first end and said undercowl component.
15. The gas turbine engine in accordance with any of clauses 9 to 14, wherein said cold sink includes a valve body, an annular fan casing, an annular inner housing, an outer guide vane, and a thrust link support.
16. The gas turbine engine in accordance with any of clauses 9 to 15, wherein said electronic component comprises a circuit board, a heat sink, and a chassis, the circuit board disposed inside of the chassis, the heat sink thermally coupled to the circuit board, said first end thermally coupled to the heat sink, said heat pipe extending through the chassis, wherein:
   the heat sink facilitates transfer of the quantity of heat from the circuit board to said first end; and
   said heat pipe facilitates further transfer of the quantity of heat from said first end to said cold sink.
17. A method of cooling a gas turbine engine, the gas turbine engine including a core engine, a cold sink, a core undercowl space, an undercowl component positioned in the core undercowl space, and a core cowl at least partially surrounding the core engine and defining a radially outer wall of the core undercowl space, said method comprising:
   selecting a heat pipe having performance parameters to facilitate following a predetermined heat transfer characteristic including a thermal resistance between the undercowl component and the cold sink;
   thermally coupling a first end of the heat pipe to the undercowl component;
   thermally coupling a second end of the heat pipe to the cold sink;
   receiving heat into the first end from the undercowl component; and
   transferring heat through the heat pipe to the cold sink.
18. The method in accordance with clause 17, wherein the undercowl component includes an electronic component, the electronic component including a circuit board, a heat sink, and a chassis, the circuit board disposed inside of the chassis, said thermally coupling a first end of the heat pipe to the undercowl component comprising:
   coupling the heat sink to the circuit board;
   extending the heat pipe through the chassis; and
   coupling the first end to the heat sink, said transferring heat through the heat pipe to the cold sink comprising:
      transferring heat from the circuit board to the heat sink; and
      further transferring heat from the heat sink to the cold sink.
19. The method in accordance with clause 17 or 18, said thermally coupling a second end of the heat pipe to the cold sink comprising thermally coupling the second end to a valve body, an annular fan casing, an annular inner housing, an outer guide vane, and a thrust link support.
20. The method in accordance with any of clauses 17 to 19, further comprising:
   thermally coupling an evaporator to and between the first end and the undercowl component; and
   thermally coupling a condenser to and between the second end and the cold sink.

## Claims

1. A gas turbine engine cooling system (400,500,600) for a gas turbine engine (100), the gas turbine engine including a core engine (102), a cold sink (602,202,316,302,702), a core undercowl space (131), and a core cowl (130) at least partially surrounding the core engine and defining a radially outer wall of the core undercowl space, said gas turbine engine cooling system comprising:
an undercowl component (402) positioned in the core undercowl space; and
a heat pipe (414) comprising a first end (416), a second end (418), and a conduit (420) extending therebetween, said second end thermally coupled to the cold sink, said first end thermally coupled to said undercowl component, wherein said heat pipe facilitates transfer of a quantity of heat from said undercowl component to the cold sink.

2. The gas turbine engine cooling system (400,500,600) in accordance with Claim 1, wherein said undercowl component (402) comprises an electronic component.

3. The gas turbine engine cooling system (400,500,600) in accordance with Claim 2, wherein said electronic component (402) comprises a full authority digital engine (or electronics) control (FADEC).

4. The gas turbine engine cooling system (400,500,600) in accordance with any preceding Claim, wherein said undercowl component (402) comprises a non-electronic component.

5. The gas turbine engine cooling system (400,500,600) in accordance with any preceding Claim, further comprising at least one condenser (412) thermally coupled to and between said second end (418) and the cold sink (602,202,316,302,702).

6. The gas turbine engine cooling system (400,500,600) in accordance with any preceding Claim, further comprising at least one evaporator (410) thermally coupled to and between said first end (416) and said undercowl component (402).

7. The gas turbine engine cooling system (400,500,600) in accordance with any preceding Claim, wherein the cold sink (602,202,316,302,702) comprises a valve body (602), an annular fan casing (202), an annular inner housing (316), an outer guide vane (302), and a thrust link support (702).

8. The gas turbine engine cooling system (400,500,600) in accordance with any of Claims 2 to 7, wherein said electronic component comprises a circuit board (406), a heat sink (408), and a chassis (404), the circuit board disposed inside of the chassis, the heat sink thermally coupled to the circuit board, said first end (416) thermally coupled to the heat sink, said heat pipe (414) extending through the chassis, wherein:
the heat sink facilitates transfer of the quantity of heat from the circuit board to said first end; and
said heat pipe facilitates further transfer of the quantity of heat from said first end to said cold sink.

9. A gas turbine engine (100) comprising:
a core engine (102);
a cold sink (602,202,316,302,702);
a core undercowl space (131);
a core cowl (130) at least partially surrounding said core engine and defining a radially outer wall of said core undercowl space;
an undercowl component (402) positioned in said core undercowl space; and
a cooling system (400,500,600) comprising a heat pipe (414) including a first end (416), a second end (418), and a conduit (420) extending therebetween, said second end thermally coupled to said cold sink, said first end thermally coupled to said undercowl component, wherein said heat pipe facilitates transfer of a quantity of heat from said undercowl component to said cold sink.

10. The gas turbine engine (100) in accordance with Claim 9, wherein said undercowl component (402) comprises an electronic component.

11. The gas turbine engine (100) in accordance with Claim 9 or Claim 10, wherein said undercowl component (402) comprises a non-electronic component.

12. The gas turbine engine (100) in accordance with any of Claims 9 to 11, further comprising at least one condenser (412) thermally coupled to and between said second end (418) and said cold sink (602,202,316,302,702).

13. The gas turbine engine (100) in accordance with any of Claims 9 to 12 further comprising at least one evaporator (410) thermally coupled to and between said first end (416) and said undercowl component (402).

14. The gas turbine engine (100) in accordance with any of Claims 9 to 13, wherein said cold sink (602,202,316,302,702) includes a valve body (602), an annular fan casing (202), an annular inner housing (316), an outer guide vane (302), and a thrust link support (702).

15. A method of cooling a gas turbine engine, the gas turbine engine (100) including a core engine (102), a cold sink (602,202,316,302,702), a core undercowl space (131), an undercowl component (402) positioned in the core undercowl space (131), and a core cowl (130) at least partially surrounding the core engine and defining a radially outer wall of the core undercowl space (131), said method comprising:
selecting a heat pipe (414) having performance parameters to facilitate following a predetermined heat transfer characteristic including a thermal resistance between the undercowl component (402) and the cold sink (602,202,316,302,702);
thermally coupling a first end (416) of the heat pipe (414) to the undercowl component (402);
thermally coupling a second end (418) of the heat pipe (414) to the cold sink (602,202,316,302,702);
receiving heat into the first end (416) from the undercowl component (402); and
transferring heat through the heat pipe (414) to the cold sink (602,202,316,302,702).
